# EUROPÄISCHE PATENTSCHRIFT

(11) **EP 0 516 623 B1**
(45) Veröffentlichungstag und Bekanntmachung des Hinweises auf die Patenterteilung: **23.08.1995**
(21) Anmeldenummer: 90916235.6
(22) Anmeldetag: 09.11.1990
(51) Int. Cl.: H01R 13/66, H05K 5/00

(54) **REGLER-BAUSTEIN FÜR DIE ANSTEUERUNG VON RELAIS**
CONTROL COMPONENT TO DRIVE RELAYS
ELEMENT REGULATEUR DE L'EXCITATION D'UN RELAIS

(30) Priorität: 23.02.1990 DE 4005809
(43) Veröffentlichungstag der Anmeldung: 09.12.1992
(73) Patentinhaber: SIEMENS AKTIENGESELLSCHAFT, 80333 München (DE)
(72) Erfinder: VON GUTTENBERG, Florenz, D-1000 Berlin 45 (DE)
(86) Internationale Anmeldenummer: DE9000859
(87) Internationale Veröffentlichungsnummer: WO9113478

(56) Entgegenhaltungen:
- FR-A- 2 271 668
- GB-A- 2 158 658
- GB-A- 2 180 415

## Beschreibung

Die Erfindung betrifft einen Regler-Baustein für die Ansteuerung von Relais oder dergleichen mit einer in einem Gehäuse angeordneten integrierten Schaltungsanordnung und mit nach einer Seite aus dem Gehäuse austretenden Anschlußelementen.

Für die Ansteuerung von Relais ist es bekannt, mittels einer integrierten Schaltung die Spulenspannung oder den Spulenstrom zu regeln oder auch eine Impulsansteuerung nach bestimmten Regelkriterien vorzunehmen. Dabei ist es auch bekannt, einen integrierten Baustein im Relaisgehäuse zusätzlich zum Relaissystem unterzubringen. Dies scheitert jedoch in manchen Anwendungsfällen an der Wärmeempfindlichkeit der integrierten Schaltung, wenn nämlich aufgrund der Umgebungstemperatur, der Eigenerwärmung der Relaisspule und der zusätzlichen Eigenerwärmung des integrierten Bausteins die zulässige Temperatur für den Baustein überschritten wird. Solche Verhältnisse herrschen beispielsweise bei Relais, die in Kraftfahrzeugen betrieben werden.

Es ist auch bekannt, integrierte Schaltungen für die Relaisansteuerung mit einer eigenen Ummantelung oder auch mit einem eigenen Gehäuse zu versehen und neben dem anzusteuernden Relais auf einer Leiterplatte unterzubringen. Handelt es sich jedoch um steckbare Relais in entsprechenden Steckfassungen für einzelne oder für eine ganze Gruppe von Relais, so würde die Anfügung eines derartigen Bausteines mit Lötfahnen eine eigene Leiterplatte für diesen Zweck mit entsprechenden Fertigungs- und Verdrahtungsschritten erfordern, wobei die zusätzlichen Konstruktions- und Montageschritte einen unverhältnismäßig hohen Aufwand im Vergleich zum Ansteuer-Baustein selbst bedeuten würden.

Es ist zwar auch bereits bekannt, integrierte Schaltungsbausteine in entsprechenden Gehäusen unterzubringen, die ihrerseits mit Steckerstiften versehen sind (DE-A-24 23 623, DE-U-84 33 699). Dort handelt es sich jedoch um an die Form von Speicherbausteinen angepaßte flache Gehäuse, während die Steckerstifte entsprechend den geringen fließenden Strömen auch nur geringen Querschnitt haben, so daß Bausteine in dieser bekannten Art in einer Relaiskonstruktion, beispielsweise in Steckfassungen, wie sie für Relais in Kraftfahrzeugen vorgesehen sind, nicht ohne weiteres eingesetzt werden können.

Dies gilt auch für einen Baustein, wie er in der DE-C-36 14 919 beschrieben ist. Dort ist ein Baustein in der eingangs genannten Weise in einem Miniaturgehäuse angeordnet und mit Anschlußstiften versehen. Das Miniaturgehäuse ist dann in einer offenen Kammer an der Anschlußseite des Relais untergebracht, so daß die Anschlußstifte des Regel-Bausteins zusammen mit den Anschlußstiften des Relais auf einer Leiterplatte verlötet werden können. Eine Übertragung dieser Anordnung auf Kraftfahrzeugrelais oder ähnliche Anwendungen ist schon wegen der Wärmeentwicklung bedenklich.

In der GB-A-2 180 415 ist weiterhin eine Anordnung einer elektronischen Baugruppe in einem größeren Anschlußkomplex beschrieben, wobei die auf einer Leiterplatte aufgebaute und in einem eigenen Gehäuse untergebrachte elektronische Baugruppe in einer Aufnahme angeordnet und über Steckverbinder mit der übergeordneten Baugruppe sowie nach außen verbunden ist. Unter anderem ist ein Flachsteck-Anschlußelement von der Haupt-Baugruppe durch das Gehäuse der elektronischen Baugruppe hindurch nach außen geführt, ohne unmittelbar mit der elektronischen Schaltung in diesem Gehäuse verbunden zu sein. Für die Ansteuerung einzelner Relais oder Relaisgruppen ist die dortige elektronische Schaltungsbaugruppe jedoch zu aufwendig; sie wäre auch ohne konstruktive Änderungen nicht an die üblichen Steckverbindungen der Relais anzupassen.

Aufgabe der Erfindung ist es, einen Regler-Baustein der eingangs genannten Art so zu gestalten, daß er ohne wesentliche konstruktive Aufwendungen in Schaltungen mit steckbaren Relais, insbesondere auch zur Ansteuerung von Relaisgruppen in Kraftfahrzeugen, geeignet ist.

Erfindungsgemäß wird diese Aufgabe dadurch gelöst, daß das Gehäuse als bewegliches Steckteil nach Form und Größe dem Gehäuse eines Relais oder Steckverbinders entspricht, daß die Anschlußelemente als Flachstecker oder Flachsteckhülsen nach einem für Relais vorgegebenen Rastermaß, insbesondere nach einer Norm für Kraftfahrzeugrelais, angeordnet und gestaltet sind und daß die integrierte Schaltungsanordnung im Gehäuseinneren mit ihren Anschlußfahnen auf die Enden der Flachsteckern bzw. Flachsteckhülsen verbunden ist. Der Baustein besitzt also in einer Ausführungsform ein Gehäuse eines Relais, in dessen Sockel die Flachstecker mit gleichen Abmessungen und gleichem Raster wie beim Relais verankert sind, wobei anstelle des Relaissystems die integrierte Schaltungsanordnung im Gehäuseinneren mit ihren Anschlußfahnen auf die Enden der Flachstecker aufgelötet oder aufgeschweißt ist. Damit ergibt sich eine unerwartet einfache und sehr wirtschaftliche Lösung, da durch die Verwendung von Seriengehäusen eine eigene Konstruktion und Fertigung nicht erforderlich ist. Diese Relaisgehäuse sind zwar in der Regel wesentlich größer als für die integrierte Schaltungsanordnung benötigt, außerdem sind die für hohe Ströme ausgelegten Flachstecker an sich bei weitem überdimensioniert für die geringen Ströme der integrierten Schaltungsanordnung, doch fällt dies im Vergleich zu den Vorteilen nicht ins Gewicht. Der wesentliche Vorteil besteht zudem darin, daß ein erfindungsgemäß gestalteter Regler-Baustein neben einem Relais bzw. anstelle eines Relais in die genormte Steckfassung für Relais eingesteckt werden kann, wobei durch eine entsprechend geringfügige Anpassung der Verdrahtung das in der Regel daneben sitzende Relais oder eine gesamte Relaisgruppe kostengünstig in einem gemeinsamen Gehäuse beispielsweise mit geregelter Spannung angesteuert werden kann. Wie erwähnt, machen sich diese Vorteile insbesondere beim Einsatz in Kraftfahrzeugen bemerkbar, wo einerseits aufgrund sonstiger Einflüsse hohe Schwankungen der Batteriespannung auftreten, andererseits im Sinn rationeller Fertigung möglichst einheitliche Befestigungs-und Kontaktierungselemente erwünscht sind. Wichtig ist dabei vor allem auch die leichte Austauschbarkeit von Bausteinen im Zuge von Wartung und Reparatur.

Falls die integrierte Schaltungsanordnung in dem Baustein eine höhere Verlustleistung und damit eine höhere Eigenerwärmung aufweist, beispielsweise bei der parallelen Ansteuerung einer ganzen Relaisgruppe, können in dem freien Raum des Gehäuses Kühlkörper und dergleichen untergebracht werden. Zweckmäßig könnte in diesem Fall auch das Ausgießen des Gehäuses mit einer wärmeleitenden Masse sein.

Beim Einsatz des erfindungsgemäßen Bausteins in einem Kraftfahrzeug ist neben der bereits genannten Ansteuerung einer Relaisgruppe in einer gemeinsamen Relaisbox natürlich auch eine Einzelansteuerung möglich. In diesem Fall kann der Baustein auch an einer beliebigen Stelle des Kabelbaumes eingesetzt werden. Dabei kann natürlich in vorteilhafter Weise auch ein Regler für den Spulenstrom eingesetzt werden. Mit den Flachstekkern ist es auch möglich, den Regler-Baustein ohne Steckfassung mit Kabelschuhen an beliebigen dezentralen Stellen des Kraftfahrzeugs anzuschließen.

In einer Abwandlung kann der erfindungsgemäße Baustein aber auch in einem Steckergehäuse verwirklicht werden. Er kann dann mit Flachsteckern im üblichen Steckerraster in entsprechenden Steckaufnahmen an beliebigen Stellen in einem Kraftfahrzeug untergebracht werden, um über ein Kabel angeschlossene Relais anzusteuern.

Die Erfindung wird nachfolgend an Ausführungsbeispielen anhand der Zeichnung näher erläutert. Es zeigt
Figur 1 einen Regler-Baustein mit einem Relaisgehäuse in perspektivischer Darstellung,
Figur 2 ein Schaltbild für die Versorgung einer Relais-Box in einem Kraftfahrzeug mit einem Regler-Baustein,
Figur 3 bis 5 einen fertig montierten, gegenüber Figur 1 etwas abgewandelten Regler-Baustein in drei Ansichten,
Figur 6 ein erfindungsgemäßer Baustein in einem Steckergehäuse.

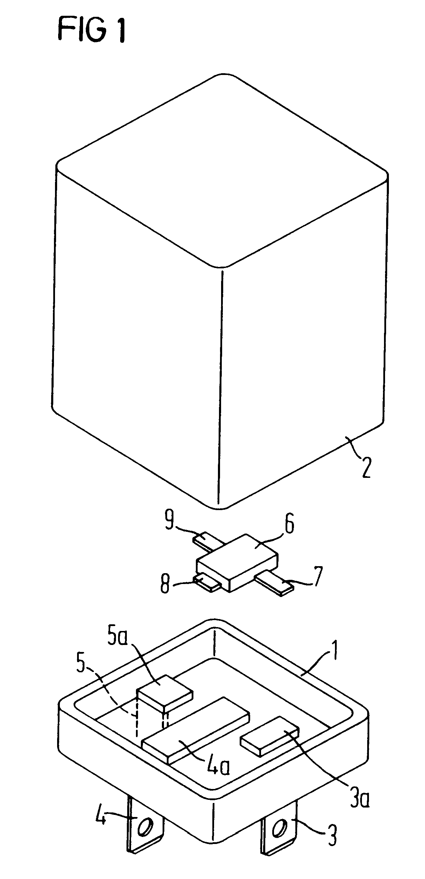

Figur 1 zeigt den prinzipiellen Aufbau eines nur leicht modifizierten Relaisgehäuses zur Aufnahme einer integrierten Schaltungsanordnung. Das Gehäuse besteht aus einer Bodenplatte bzw. einem Sockel 1 und einer von oben aufgestülpten Kappe 2. In dem Sockel sind in üblicher Weise, beispielsweise durch Einbetten oder Einstecken, Flachstecker 3, 4 und 5 verankert. Deren innere Endabschnitte 3a, 4a und 5a sind auf der Innenseite des Sokkels parallel zum Boden abgebogen, so daß sie ebene Auflageflächen bilden. Auf diese Endabschnitte 3a, 4a und 5a ist eine integrierte Schaltungsanordnung 6 mit entsprechenden Anschlußfahnen 7, 8 und 9 aufgesetzt, wobei die genannten Anschlußfahnen mit den entsprechenden Stecker-Endabschnitten 3a, 4a und 5a verbunden, beispielsweise verlötet oder verschweißt, sind. Durch Aufsetzen der Kappe 2 wird der fertige Regler-Baustein verschlossen. Sollte die integrierte Schaltungsanordnung eine höhere Verlustleistung aufweisen, kann im Gehäuse ein Kühlkörper oder eine wärmeleitende Vergußmasse untergebracht werden.

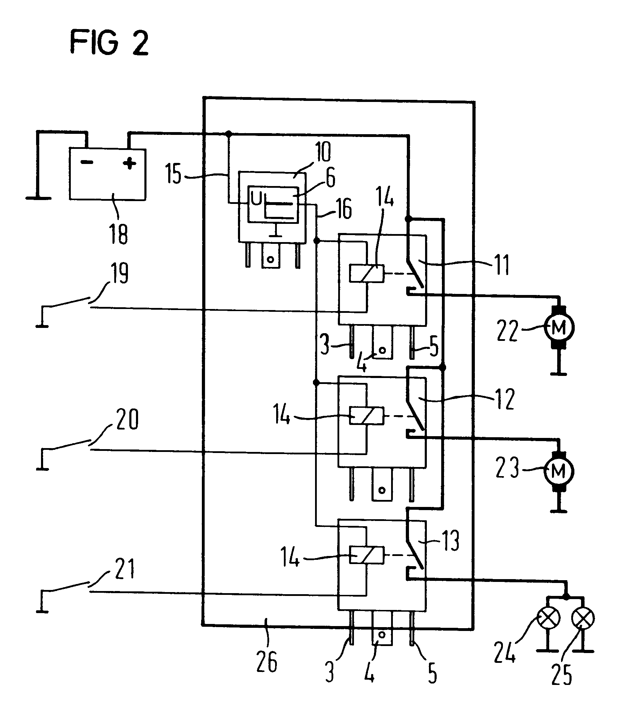

Die Figur 2 zeigt ein Beispiel für den Einsatz eines erfindungsgemäßen Regler-Bausteins in einem Kraftfahrzeug zur Versorgung einer Relaisgruppe mit geregelter Spannung. Der Regler-Baustein 10 ist dabei zusammen mit mehreren Relais 11, 12 und 13 in einer gemeinsamen Relais-Box 26 untergebracht. Da der Regler-Baustein die gleichen Flachstecker 3, 4 und 5 wie die Relais aufweist, kann er neben den Relais in einer der gleich gestalteten Steckfassungen untergebracht werden. Bei der gezeigten Spannungsregelung in der integrierten Schaltungsanordnung 6 sind lediglich drei Anschlüsse erforderlich, nämlich ein Spannungseingang 15, ein Spannungsausgang 16 und ein Masseanschluß 17. Die in Figur 2 schematisch gezeigten Anschlüsse sind natürlich in der Praxis über die Flachstecker 3, 4 und 5 herausgeführt. Der Spannungseingang 15 ist parallel zu den Lasteingängen der Relais an eine Batterie 18 angeschaltet, während der Spannungsausgang 16 jeweils parallel an einen Spulenanschluß der Erregerspulen 14 geschaltet ist. Die jeweils anderen Spulenenden sind getrennt zu jeweils einem Schalter 19, 20 bzw. 21 geführt, so daß jedes Relais getrennt geschaltet werden kann. Mit den Relais 11, 12 und 13 werden die verschiedenen Verbraucher in dem Kraftfahrzeug, beispielsweise Motoren 22 und 23 und Lampen 24 und 25, geschaltet.

Der Aufbau der integrierten Schaltungsanordnung 6 selbst braucht hier nicht weiter erörtert zu werden, da er einer üblichen und dem Fachmann bekannten Spannungsregelungsschaltung entspricht. Anstelle der hier im Beispiel genannten Spannungsregelung könnte aber auch eine Stromregelung oder beispielsweise auch eine getaktete Ansteuerung der Relais vorgesehen werden. Derartige integrierte Schaltungen sind allerdings aufwendiger und damit teuerer als die hier vorgesehene einfache Spannungsregelung.

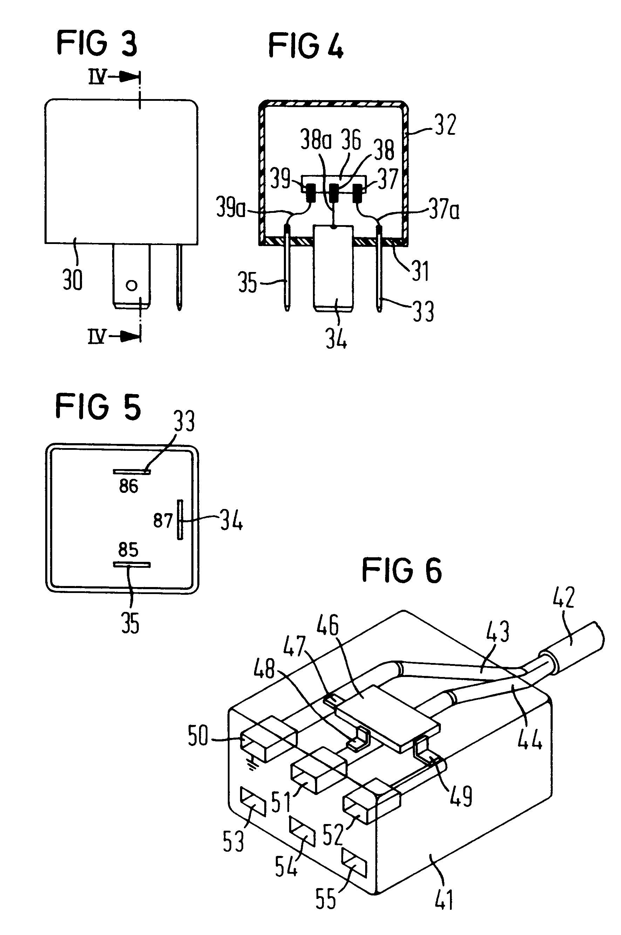

In den Figuren 3 bis 5 ist ein fertiger Baustein 30 in zwei verschiedenen Ansichten und in einem Schnitt gezeigt. Dabei ist die Anordnung und Befestigung bzw. Kontaktierung der integrierten Schaltungsanordnung 36 gegenüber Figur 1 geringfügig abgeändert. Die Anschlußfahnen 37, 38 und 39 der integrierten Schaltungsanordnung 36 sind über Verbindungsdrähte 37a, 38a und 39a an die jeweiligen Flachstecker 33, 34 und 35 geführt, so daß die integrierte Schaltungsanordnung frei im Innenraum des aus Sockel 31 und Kappe 32 gebiloeten Gehäuses sitzt.

In Figur 5 ist eine Ansicht von unten auf die Anschlußlage des Bausteines 30 gezeigt. Dabei ist zu erkennen, daß die Flachstecker 33, 34 und 35 gemäß der internationalen Norm ISO 7588 für Kraftfahrzeugrelais angeordnet sind. Damit ist sichergestellt, daß der Baustein ohne weiteres in eine Steckfassung für Relais eingesetzt werden kann.

Figur 6 zeigt eine weitere Ausführungsform des Regler-Bausteins, wobei ein Steckergehäuse verwendet ist. Das Steckergehäuse 41 ist nur in den Umrissen angedeutet. Von einer Seite ist in das Steckergehäuse ein Kabel 42 eingeführt, von dem zwei Leitungsadern 43 und 44 gezeigt sind. Diese Leitungsadern 43 und 44 sind mit Anschlußfahnen 47 und 48 eines integrierten Schaltungselementes 46 kontaktiert, welches in dem Steckergehäuse angeordnet ist. Beispielsweise kann die Leitungsader 43 eine Masseleitung sein, während an der Leitungsader 44 eine ungeregelte Kraftfahrzeugspannung anliegt. Dann kann über die integrierte Schaltungsanordnung 46 an der Anschlußfahne 49 eine geregelte Spannung abgegeben werden. Über die Steckerhülsen 50, 51 und 52 kann dann auf einen Gegenstecker, der nicht gezeigt ist, jeweils das entsprechende Potential weitergegeben werden, also über die Steckerhülse 50 das Massepotential, über die Steckerhülse 51 die ungeregelte Spannung und über die Steckerhülse 52 die geregelte Spannung. Diese geregelte Spannung kann dann über den Stecker zu einem an beliebiger Stelle angeordneten Relais oder auch zu einem entsprechenden anderen Bauelement geführt werden. An den Steckerhülsen 53, 54 und 55 können weitere Steuerleitungen angeschlossen sein.

## Patentansprüche

1. Regler-Baustein für die Ansteuerung von Relais mit einer in einem Gehäuse (1, 2; 31, 32; 41) angeordneten integrierten Schaltungsanordnung (6; 36; 46) und mit nach einer Seite aus dem Gehäuse austretenden Anschlußelementen (3, 4, 5; 33, 34, 35; 50 bis 55), **dadurch gekennzeichnet**, daß das Gehäuse (1, 2; 31, 32; 41) als bewegliches Steckteil nach Form und Größe dem Gehäuse eines Relais oder Steckverbinders entspricht, daß die Anschlußelemente als Flachstecker (3, 4, 5; 33, 34, 35) oder Flachsteckhülsen (50 bis 55) nach einem für Relais vorgegebenen Rastermaß, insbesondere nach einer Norm für Kraftfahrzeugrelais, angeordnet und gestaltet sind und daß die integrierte Schaltungsanordnung (6; 36; 46) im Gehäuseinneren mit ihren Anschlußfahnen auf die Enden der Flachsteckern bzw. Flachsteckhülsen verbunden ist.

2. Baustein nach Anspruch 1, **dadurch gekennzeichnet**, daß das Gehäuse einen Sockel (1; 31) und eine Kappe (2; 32) aufweist, wobei die Flachstecker im Sockel verankert sind.

3. Baustein nach Anspruch 1, **dadurch gekennzeichnet**, daß das Gehäuse ein Steckergehäuse (41) ist, bei dem an einer Seite ein Kabel (42) eingeführt ist und bei dem an der dem Kabel gegenüberliegenden Seite Flachsteckhülsen (50 bis 55) oder Flachstecker angeordnet sind.

4. Baustein nach einem der Ansprüche 1 bis 3, **dadurch gekennzeichnet**, daß das Gehäuse (1, 2; 31, 32; 41) mit einer wärmeleitenden Masse ausgefüllt ist.

5. Baustein nach einem der Ansprüche 1 bis 3, **dadurch gekennzeichnet**, daß in dem Gehäuse (1, 2; 31, 32; 41) ein Kühlkörper mit der integrierten Schaltungsanordnung (6; 36; 46) verbunden ist.

6. Baustein nach einem der Ansprüche 1 bis 5, **dadurch gekennzeichnet**, daß die integrierte Schaltungsanordnung (6; 36; 46) eine Schaltung zur Spannungsregelung enthält.

7. Verwendung eines Bausteins nach einem der Ansprüche 1 bis 6, **dadurch gekennzeichnet**, daß der Baustein (6) in einem Kraftfahrzeug mit seinem Eingang an einer Batteriespannung (18) angeschaltet ist und an seinem Ausgang eine geregelte Steuerspannung für mindestens ein Relais (11, 12, 13) im Kraftfahrzeug abgibt.

8. Verwendung des Bausteins nach Anspruch 7, **dadurch gekennzeichnet**, daß er in einem mehrere Relais (11, 12, 13) enthaltenden Gehäuse (26) in einer Relais-Steckfassung angeordnet wird.

9. Verwendung des Bausteins nach Anspruch 7, **dadurch gekennzeichnet**, daß er an einer peripheren Stelle in einem Kraftfahrzeug zur Ansteuerung eines dezentral angeordneten Relais verwendet wird.

## Claims

1. Controller module for driving relays, having an integrated circuit arrangement (6; 36; 46) arranged in a housing (1, 2; 31, 32; 41) and having connecting elements (3, 4, 5; 33, 34, 35; 50 to 55) emerging to one side out of the housing, characterized in that the housing (1, 2; 31, 32; 41), as a movable plug part, corresponds in shape and size to the housing of a relay or plug connector, in that the connecting elements are arranged and designed as flat plug pins (3, 4, 5; 33, 34, 35) or flat plug sockets (50 to 55) in accordance with a grid size specified for relays, preferably in accordance with a standard for motor vehicle relays, and in that the integrated circuit arrangement (6; 36; 46) is connected in the interior of the housing by its connecting lugs to the ends of the flat plug pins or flat plug sockets.

2. Module according to Claim 1, characterized in that the housing has a base (1; 31) and a cap (2; 32), the flat plug pins being anchored in the base.

3. Module according to Claim 1, characterized in that the housing is a plug housing (41) in which a cable (42) is inserted on one side and in which flat plug sockets (50 to 55) or flat plug pins are arranged on the side opposite the cable.

4. Module according to one of Claims 1 to 3, characterized in that the housing (1, 2; 31, 32; 41) is filled with a heat-conducting compound.

5. Module according to one of Claims 1 to 3, characterized in that a cooling body is connected to the integrated circuit arrangement (6; 36; 46) in the housing (1, 2; 31, 32; 41).

6. Module according to one of Claims 1 to 5, characterized in that the integrated circuit arrangement (6; 36; 46) contains a circuit for voltage control.

7. Use of a module according to one of Claims 1 to 6, characterized in that the module (6) is connected in a motor vehicle with its input to a battery voltage (18) and emits at its output a controlled control voltage for at least one relay (11, 12, 13) in the motor vehicle.

8. Use of the module according to Claim 7, characterized in that the said module is arranged in a relay plug socket in a housing (27) containing a plurality of relays (11, 12, 13).

9. Use of the module according to Claim 7, characterized in that the said module is used at a peripheral point in a motor vehicle to drive a relay arranged in a decentralized manner.

## Revendications

1. Elément régulateur de l'excitation d'un relais, comprenant un circuit intégré (6; 36; 46) situé dans un boîtier (1, 2; 31, 32; 41) et des éléments de connexion (3, 4, 5; 33, 34, 35; 50 à 55) sortant du boîtier sur un côté, caractérisé en ce que le boîtier (1, 2; 31, 32; 41) étant un élément enfichable mobile, correspond, par sa forme et par sa taille, au boîtier d'un relais ou d'un connecteur multiple, en ce que les éléments de branchement sont formés et positionnés de la même façon que des fiches plates (3, 4, 5; 33, 34, 35) ou que des alvéoles pour contacts plats (50 à 55), conformément à une dimension de trame définie pour les relais et, plus particulièrement à une norme pour les relais de véhicules automobiles, et en ce que le circuit intégré (6; 36; 46) est relié à l'intérieur du boîtier, grâce à ses barrettes, aux extrémités des fiches plates ou aux alvéoles pour contacts plats.

2. Elément selon la revendication 1, caractérisé en ce que le boîtier comporte un socle (1; 31) et un couvercle (2; 32), les fiches plates étant ancrées dans le socle.

3. Elément selon la revendication 1, caractérisé en ce que le boîtier forme un logement de prise (41) dans lequel un câble (42) est introduit sur un côté et des alvéoles pour contacts plats (50 à 55) ou des fiches plates sont situé(e)s sur le côté opposé au câble.

4. Elément selon l'une des revendications 1 à 3, caractérisé en ce que le boîtier (1, 2; 31, 32; 41) est rempli d'une masse conductrice de chaleur.

5. Elément selon l'une des revendications 1 à 3, caractérisé en ce que, dans le boîtier (1, 2; 31, 32; 41), un dissipateur de chaleur est relié au circuit intégré (6; 36; 46).

6. Elément selon l'une des revendications 1 à 5, caractérisé en ce que le circuit intégré (6; 36; 46)contient un circuit de régulation de tension. 6

7. Utilisation d'un élément selon l'une des revendications 1 à 6, caractérisée en ce que, dans un véhicule automobile, I'élément (6) est branché, à son entrée, sur une tension de batterie (18) et qu'il délivre à sa sortie une tension de commande régulée pour au moins un relais (11, 12, 13) dans le véhicule automobile.

8. Utilisation de l'élément selon la revendication 7, caractérisée en ce qu'il est situé dans un boîtier (26) contenant plusieurs relais (11, 12, 13) dans une douille à prise pour relais.

9. Utilisation de l'élément selon la revendication 7, caractérisée en ce qu'il est utilisé dans un endroit périphérique du véhicule automobile pour l'excitation d'un relais situé de manière décentralisée.
